# EUROPEAN PATENT SPECIFICATION

(11) **EP 0 779 772 B1**
(45) Date of publication and mention of the grant of the patent: **04.06.2003**
(21) Application number: 95932236.3
(22) Date of filing: 26.09.1995
(51) Int. Cl.: H05K 1/02

(54) **PRINTED WIRING BOARD, METHOD OF PRODUCING THE SAME AND ELECTRONIC DEVICES**
LEITERPLATTE, VERFAHREN ZU DEREN HERSTELLUNG UND ELEKTRONISCHE VORRICHTUNGEN
CARTE A CIRCUIT IMPRIME, SON PROCEDE DE PRODUCTION ET DISPOSITIFS ELECTRONIQUES

(30) Priority: 27.09.1994 JP 23162894
(43) Date of publication of application: 18.06.1997
(73) Proprietor: SEIKO EPSON CORPORATION, Shinjuku-ku, Tokyo 163-0811 (JP)
(72) Inventor: UCHIYAMA, Kenji Seiko Epson Corporation, Suwa-shi Nagano-ken 392 (JP)
(74) Representative: Hoffmann, Eckart, Dipl.-Ing.
(86) International application number: PCT/JP95/01941
(87) International publication number: WO 96/010326

(56) References cited:
- EP-A- 0 338 150
- EP-A- 0 460 668
- DE-A- 4 229 778
- JP-A- 2 260 598
- JP-A- 2 280 395
- JP-A- 3 074 892
- JP-A- 3 257 985
- JP-A- 4 112 594
- JP-B- 60 013 274
- JP-U- 53 008 575
- JP-U- 53 064 248
- JP-U- 63 022 764
- US-A- 3 716 846
- US-A- 4 815 990
- US-A- 5 288 950
- PATENT ABSTRACTS OF JAPAN vol. 18, no. 416 (E-1588), 4 August 1994 & JP 06 125037 A (MEGACHITSUPUSU KK), 6 May 1994,

## Description

### Technical Field

The present invention relates to a printed wiring board on which electronic parts including LSIs and discrete components such as resistors and diodes are mounted and to the manufacturing method of the printed wiring board. The present invention also relates to electronic apparatuses, such as LCD devices or electronic printer devices, which employ such a printed wiring board.

### Background Art

In electronic apparatuses, regardless of whether they are portable or fixed, used in a diversity of fields including OA and information-related fields, demand is today growing for a high-performance and multi-function design as well as a compact design while a miniature, light-weight and flat design is promoted. For this reason, the miniature, light-weight and flat design is also required of circuit boards and printed wiring boards that constitute the circuit boards, housed in electronic apparatuses, while high packaging density is also required in step with miniaturization of electrodes, terminals, and trace patterns.

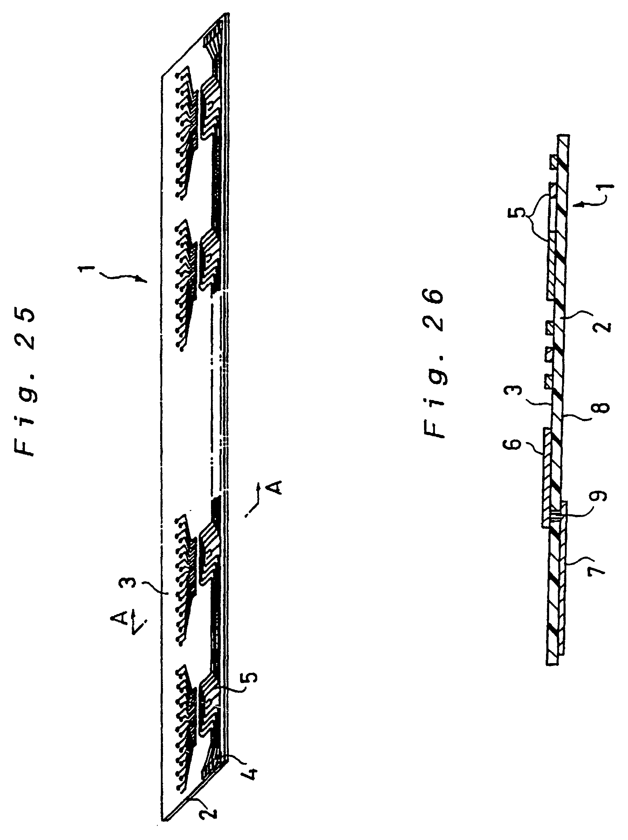

For example, as shown In Fig. 25, the specification of JP-A-5-223623 describes the printed wiring board for use in a liquid crystal display device as an example of printed wiring board employing the prior art. A printed wiring board 1 is constructed of an elongated insulating board 2 on which a plurality of liquid crystal driving semiconductor chips (not shown) are mounted, wherein the elongated insulating board 2 is provided, on its semiconductor chip mounting side surface 3, with input terminals 4, input side pattern 5 and output side pattern 6. The output terminals 7 of the wiring board 1 are formed on the bottom side 8 opposite to the semiconductor chip mounting side surface 3 as shown in Fig. 26 and are connected to the output side pattern 6 via through-holes 9. The output terminals 7 are connected to the input terminals of an unshown liquid crystal display panel, for example via an anisotropic conductive film.

Along with high packing density of the circuit board, high density and fine pitch design in the layout of the electrodes, terminals and pattern traces are promoted accordingly, and the higher density of through-holes and smaller diameter design of through-holes are thus implemented. Since the through-holes are typically formed by pressing or drilling, the level of miniaturization of through-holes suffers a limitation. Thus, promotion of fine pitch design of the through-holes and pattern traces is accordingly limited. Now, the diameter of the through-holes is typically 0.1 mm at a minimum, and the pattern layout pitch, even if the through-holes are arranged in a staggered configuration, is typically 0.2 mm at a minimum.

Fine pitch design of the through-holes may be promoted even further if they are arranged in three rows, four rows or even more rows, but the board area required for forming the through-holes is expanded with the entire circuit board getting bulky, and this reverses the direction of the miniature, light-weight and flat design. The smaller the diameter of the through-holes and the finer the pitch of the through-holes, the more difficult the drilling operation of the through-holes, and the manufacturing cost of the printed wiring board is pushed by broken drills and resulting degraded production yield. The electronic apparatuses, such as liquid crystal display devices or electronic printer devices, having such a circuit board not only fail to meet the miniature, light-weight and flat design requirement, but also end up being high manufacturing cost products.

JP-A-06-125037 discloses a printed wiring board comprising an insulating board having a first, a second and a third portion with a respective cutout portion between the first and the second portion and between the second and the third portion and with a conductor pattern on a front side of the board that continuously extends across the cutout portions, wherein the first and the second portions are folded at the respective cutout portions back onto the rear side of the board.

It is an object of the present invention to provide a low-cost and high-packaging-density adapted multi-layer printed wiring board and its manufacturing method, wherein a miniature, light-weight and flat design is implemented while a fine-pitch design of electrodes, terminals and wiring pattern traces is promoted.

It is yet another object of the present invention to promote a compact construction by implementing a miniature, light-weight, and flat design into an electronic device such as a liquid crystal display device and an electronic printer device while reducing its manufacturing cost.

### Disclosure of the Invention

These objects are achieved by a multi-layered printed wiring board as claimed in claim 1, a method as claimed in claim 10 and an electronic apparatus as claimed in claim 15, respectively. Preferred embodiments of the invention are subject-matter of the dependent claims.

### Brief Description of the Drawings

- Figs. 1(A) - (C): are perspective views showing the manufacturing method of the printed wiring board in the order of manufacturing steps, and Figs. 2(A) - (C) are corresponding cross-sectional views of a first example of a printed wiring board.
- Figs. 3(A) - (D): are plan views showing the cutout portions having different shapes formed on respective insulating boards.
- Fig. 4: is a cross-sectional view showing a second example of a printed wiring board.
- Fig. 5: is a cross-sectional view of the printed wiring board of Fig. 4 in its component-mounted state.
- Fig. 6: is a cross-sectional view showing a third example of a printed wiring board.
- Figs. 7(A),(B): are cross-sectional views showing a fourth example of a printed wiring board.
- Figs. 8(A),(B): are cross-sectional views showing a fifth example of a printed wiring board.
- Fig. 9: is a cross-sectional view showing another example of the cutout portion formed in the printed wiring board.
- Figs. 10(A),(B): are cross-sectional views showing a multi-layered printed wiring board as one embodiment of the present invention.
- Figs. 11(A) - (C): are perspective views showing another example of the manufacturing method of a printed wiring board in the order of manufacturing steps, and Figs. 12(A) - (C) are corresponding cross-sectional views of the printed wiring board.
- Fig. 13: is a perspective view of a first embodiment of a liquid crystal display device into which the present invention is embodied, and Fig. 14 is an enlarged, cross-sectional view showing the major portion of the device.
- Fig. 15: is a perspective view of a second embodiment of the liquid crystal display device, and Fig. 16 is an enlarged, cross-sectional view showing its major portion.
- Fig. 17: Is a perspective view of a portable information apparatus into which the present invention is embodied.
- Fig. 18: is a perspective view showing the electronic apparatus having an input/output device into which the present invention is embodied, and Fig. 19 is its diagrammatic cross-sectional view.
- Fig. 20: is a perspective view showing a thermal printer head Into which the present invention is embodied, and Fig. 21 is an enlarged cross-sectional view of its major portion.
- Fig. 22: Is a perspective view showing a second embodiment of the thermal printer head, and Fig. 23 is an enlarged cross-sectional view of its major portion.
- Fig. 24: is a perspective view showing an electronic printer apparatus into which the present invention is embodied.
- Fig. 25: is a perspective view showing the printed wiring board of the prior art.
- Fig. 26: is a cross-sectional view of the printed wiring board of Fig. 25.

### The Best Mode for Carrying out the Invention

Before an embodiment of the invention is explained, several examples of a printed wiring board and its manufacturing method will be described to allow for a better understanding of the invention and its preferred modifications.

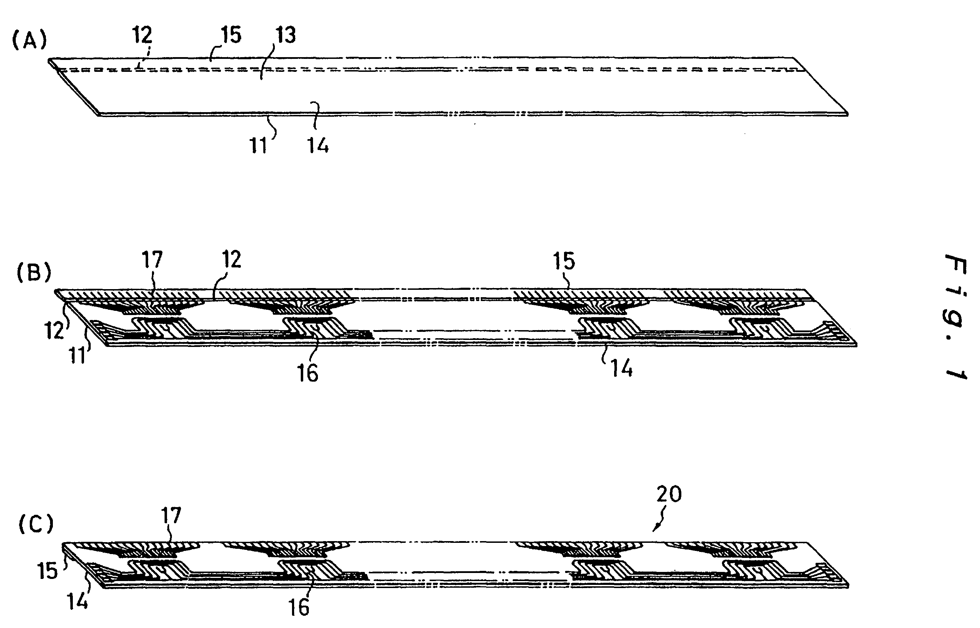

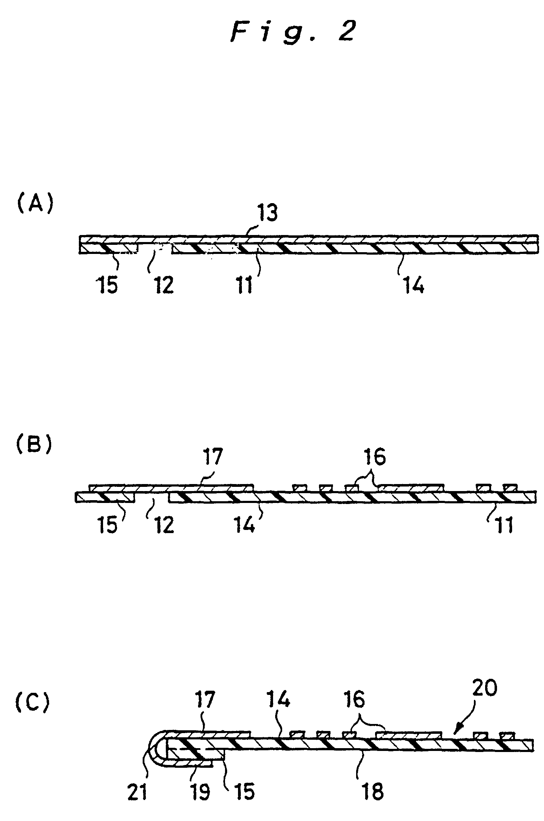

Shown in Figs. 1 (A) - (C) and Figs. 2(A) - (C) is the manufacturing method of the printed wiring board in the order of manufacturing steps. The printed wiring board herein functions as a driving circuit board for a liquid crystal display device, and mounted on it are a plurality of liquid crystal driving semiconductor chips, and in this example, an ordinary, relatively hard-natured, elongated, polyimide-resin-based insulating board 11 of 25 µm thickness is employed. Formed first is a cutout portion 12 made up of numerous consecutive slits along a predetermined fold line in parallel with one of the long sides of the insulating board 11. The width of each slit is preferably twice to four times the thickness of the insulating board 11. The cutout portion 12 is physically formed using conventionally used mechanical means such as die pressing or drilling. A conductive film 13 such as electrolytic copper film of 18 µm thickness is attached on top of the surface of the insulating board 11 (Fig. 1(A), Fig. 2(A)). The insulating board 11 is partitioned by the fold at the cutout portion 12 into a first portion 14 and a second portion 15.

Next, the conductive film 13 is patterned using a prior art technique such as photo-etching to form desired conductor patterns 16, 17. The surface of the conductor patterns are coated with Ni-Au plating not to create problems such as migration. As shown in Fig. 1(B) and Fig. 2(B), the input side conductor pattern 16 for a semiconductor chip is formed on top of the surface of the first portion 14, and the output side conductor pattern 17 is formed on the first portion 14 and the second portion 15, continuously extending across the fold at the cutout portion 12.

Next, the insulating board 11 Is folded along the fold with the output side conductor pattern 17 out, and the second portion 15 is stacked back over the bottom side 18 of the first portion 14. As already described, since nothing but copper foil constituting the conductor pattern 17 exists at the cutout portion 12, the insulating board 11 is easily folded. The first portion 14 and the second portion 15 stacked are bonded into a unitary body by thermo-compression bonding them using an appropriate bonding agent formed of a single material, or a mixture of materials or a combination of materials selected from epoxy-based resin, urethane-based resin, polyester-based resin, acrylic-based resin and the like. As an output terminal 19, the portion of the output side conductor pattern 17 formed on the second portion 15 is connected to the input terminal of a liquid crystal panel.

The printed wiring board 20 having the conductor patterns on both sides as shown in Fig. 1(C) and Fig. 2(C) is manufactured in this way. Since the cutout portion 12 allows the bent portion 21 of the conductor pattern 17 to be curved as shown in Fig. 2(C), the bent portion 21 cannot be broken easily during the bending operation of the insulating board 11 and after the printed wiring board 10 is manufactured.

The thickness of the Insulating board 11 is not limited to 25 µm, and is preferably within a range of 10 µm - 0.2 mm. Besides polyimide-based resin, as the material of the board, a single material or a composite material selected from epoxy-based resin, polyimide-based resin, BT (bismaleimide triazine) resin and the like may be used, or a composite material of glass fiber, aramid fiber or a mixture of glass fiber and aramid fiber and epoxy-based resin, polyimide-based resin, BT resin or the like may be used.

The thickness of the electrolytic copper foil for the conductive film 13 is preferably within a range of 5 µm - 50 µm. Besides the electrolytic copper foil, acceptable as the material for the conductive film 13 are rolled copper foil, alloy copper foil such as phosphor bronze foil, aluminum foil, gold foil, or metal film formed by subjecting gold, aluminum, copper, tin, zinc, nickel, chrome and the like, singly or in combination to deposition, sputtering or other process.

The surface of the conductor patterns 16, 17 may be coated with the plating of any of the materials, singly or in combination, selected from tin, solder, zinc, aluminum, chrome, nickel, gold, silver, copper and the like, besides Au-Ni plating. The surface of the conductor patterns may be coated with the metal plating even after the second portion 15 is folded as shown in Fig. 1(C) and Fig. 2(C). The thickness of the metal plating is preferably within a range of 0.1 - 5 µm. The surface of the conductor pattern does not necessarily have to undergo the above described plating process.

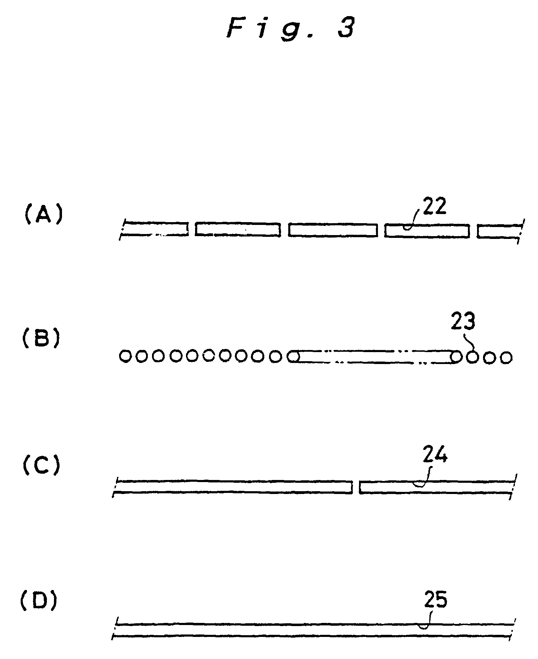

In this example, the cutout portion 12 is formed of consecutive slits 22 as shown in Fig. 3(A), and in another example, the cutout portion 12 is formed of consecutive small holes 23 as shown in Fig. 3(B). Furthermore, in yet another example, a groove 24 is formed within the area where a conductor pattern runs between the first portion and the second portion, and in this case, part of the insulating board where no conductor pattern runs is thin enough to be folded. Furthermore, as shown in Fig. 3(D), a groove 25 may be formed over the entire length of the fold. The shape of the cutout portion 12 is not limited to any of the shapes in Fig. 3(A) - (D), and may take a diversity of shapes.

The conductor patterns are formed on both sides of the printed wiring board with electric continuity allowed therebetween taking advantage of the prior art rather than using special tools, devices and facilities. Since the conductor patterns are directly connected with no need for the use of through-holes, a finer wiring and a finer wiring pitch are achieved. Since the board area required for the through-holes is dispensed with and the output side conductor pattern is folded and stacked, the entire board area is even further reduced with light-weight and flat design implemented at the same time.

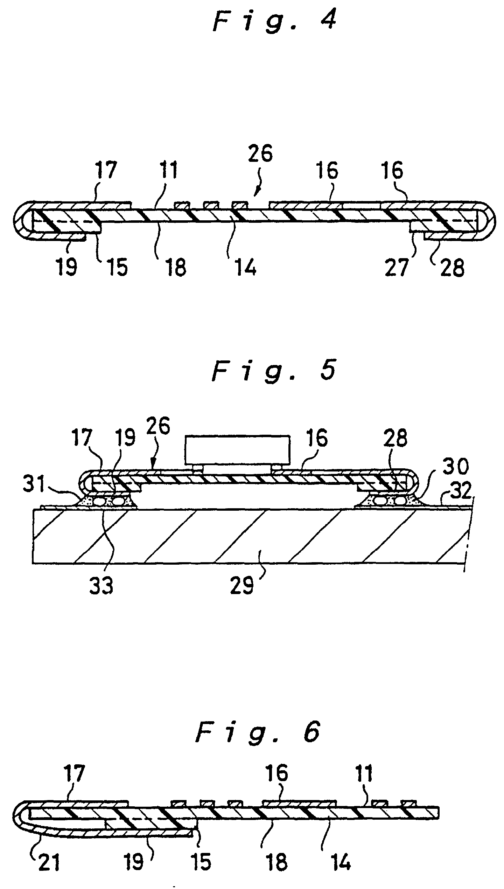

The printed wiring board 26 of the alternative example shown in Fig. 4 has a second portion 27 on the input side of the insulating board 11, the board 26 is folded with the conductor pattern 16 side out along the fold at a cutout portion formed in the same way the second portion 15 on the output side is cut out, and the second portion 27 is stacked on the bottom side 18 of the first portion 14. In this arrangement, the input side is also provided with the conductor pattern that extends continuously between both sides of the printed wiring board. By folding and stacking the conductor pattern formed on the second portion 27 used as the input terminal, the input conductor pattern is designed to be finer in the same way the output conductor pattern 17 is designed to be finer, and the printed wiring board is designed to be even more compact.

The printed wiring board 26 in Fig. 4 is mounted onto a board 29 of the main unit of an electronic apparatus as shown in Fig. 5. An input terminal 28 and an output terminal 19 are respectively connected to wirings 32, 33 on the main unit board 29 via anisotropic conductive films 30, 31.

In yet another example shown in Fig. 6, the width of the cutout portion 12 is substantially widened so that the second portion 15 is stacked at a location far into the center of the bottom 18 of the first portion. In this arrangement, the output terminal 19 is bonded to an optimum location that matches the terminal position and structure of a unit to be mated with. In this case, silicone resin, acrylic resin or urethane resin may be molded around the bent portion 21 to keep out moisture, dirt and to seal it against mechanical contact.

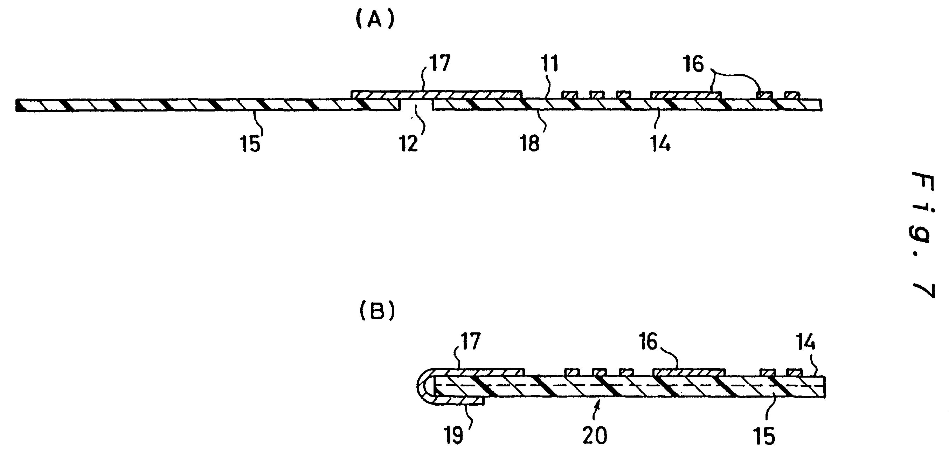

In the example shown in Figs. 7(A) and (B), the Insulating board 11 is partitioned into the first portion 14 and the second portion 15, both identical in dimensions and shape. By attaching the first portion 14 and the second portion 15 together, a printed wiring board having a substantially uniform thickness on its overall area results. When semiconductor chips and the like are mounted on the input and output conductor patterns 16, 17 on the first portion 14 in a face down fashion, uniform bonding is assured with no influence of variations in the thickness of the insulating board and a high reliability is assured. The entire printed wiring board is less susceptible to thermal deformation, and is capable of maintaining its shape reliably. Furthermore, when the printed wiring board is manufactured, the first portion and the second portion are easily aligned with each other, accuracy is enhanced, yield is improved, and manufacturing cost is reduced.

In yet another example, used as the material for the insulating board 11 is a B staged resin (a resin at its middle stage before it fully reacts to be a resin) of a single material or a composite material selected from epoxy-based resin, polyimide-based resin, BT resin and the like, or a composite material made of glass fiber, aramid fiber, a mixture of glass fiber and aramid fiber and the B staged resin of epoxy-based resin, polyimide-based resin, BT resin or the like. In this case, the folded first portion 14 and second portion 15 are attached into a unitary body by means of heat fusion rather than using a bonding agent. This arrangement allows the printed wiring board 1 to be thin, and thus the printed wiring board 1 is a dimensionally reliable printed wiring board that is highly heat-resistant and insusceptible to heat deformation.

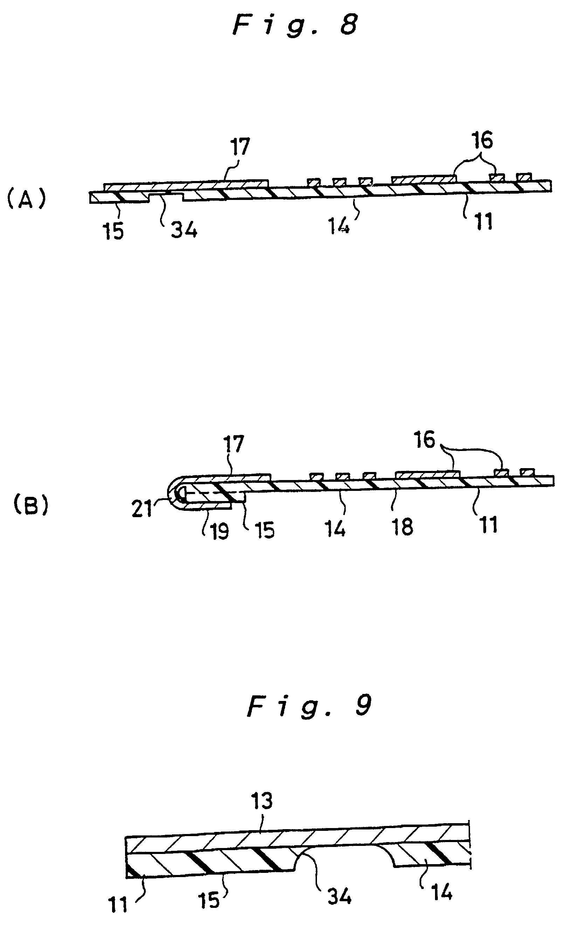

In the example shown in Figs. 8(A) and (B), a cutout portion 34 is formed of a recess that allows part of the thickness of the insulating board 11 to the conductor pattern 17 side to be left uncut. In the example, the Insulating board of polyimide resin having a thickness of 18 µm is employed, and the cutout portion 34 is formed with a thickness of 9 µm of the board material left uncut. Such a cutout portion may be formed by cutting the insulating board physicochemically (abrasion) by means of chemical etching or by directing excimer laser. In this example, a conductive film 13 having a thickness of 0.5 µm is formed on the insulating board 11 by depositing copper on the surface of the insulating board 11, then the insulating board 11 with the conductive film 13 is patterned by etching or other similar technique, and a plating process is performed to form the conductor patterns 16, 17 having a thickness of 5 µm or so.

According to this example, as shown in Fig. 8(B), the insulating board is easily folded, because the residual portion of the board material at the bent portion 21 is thin, and since the residual Insulating material reinforces the conductor pattern 17, a problem such as a break is unlikely to take place, and a highly reliable printed wiring board thus results. This arrangement allows the thickness of the conductive film 13 to be thinner. A finer conductor pattern and a finer wiring pitch thus result. In this example, copper is deposited as a conductive film 13, and then the conductive film 13 is subjected to a plating process, which increases the film thickness to 5 µm. A conductive film is perfectly acceptable without any problem as long as it is within a thickness range of 5 - 50 µm. A diversity of metal films already described with reference to the previous examples may be used as the conductive film.

As shown in Fig. 9, the cutout portion 34 is formed by cutting the board material with its both side portions remaining at the side of conductor pattern 17 and the cutout portion 34 forming slant side walls in cross section.

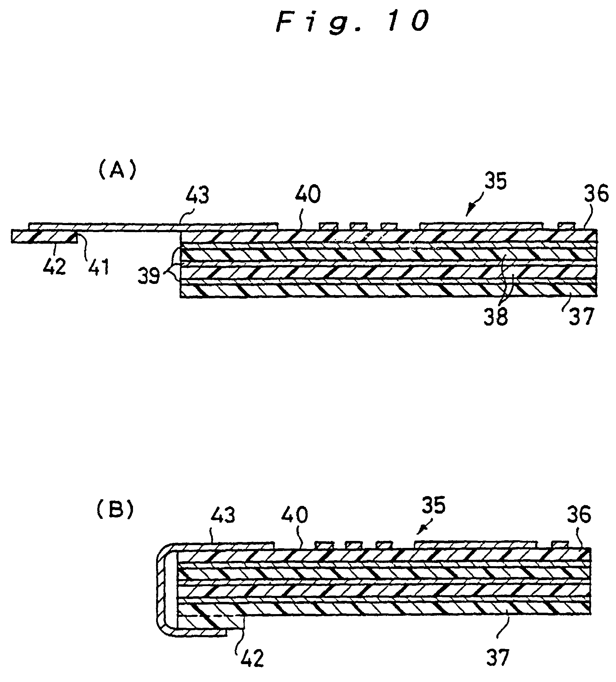

Fig. 10 shows an embodiment of the multi-layered printed wiring board according to the present invention. As shown in Fig. 10(A), the multi-layered printed wiring board 35 comprises a pair of outer-layer boards 36, 37, two inner-layer boards 38, and three layers of conductor patterns 39 sandwiched therebetween. The top outer-layer 36 comprises a first portion 40 which is identical to the other outer-layer board 37 and the inner-layer boards 38 in dimensions and shape, and which is attached onto the inner-layer board 38 immediately beneath it, and a second portion 42 that is partitioned from the first portion 40 by a cutout portion 41 that is formed in a wide width along a fold between portions 40 and 42. Formed on the surface of the outer-layer board 36 is a conductor pattern 43 that continuously runs across the cutout portion 41 between the first portion 40 and the second portion 42.

In the same way as in each of the preceding examples, the second portion 42 is folded until it is stacked over the other outer-layer board 37 with the conductor pattern 43 side out. As shown in Fig. 10(B), obtained Is the multi-layered printed wiring board 35 of five-layered construction with the wiring pattern formed on the top surface directly connected to the wiring pattern formed on the bottom surface. According to this embodiment, a finer wiring pattern and a finer pitch of wiring pattern are achieved in the printed wiring board of multi-layered construction with less through-holes, and thus a miniature, light-weight, and flat printed wiring board results, improving yield and thereby reducing manufacturing cost.

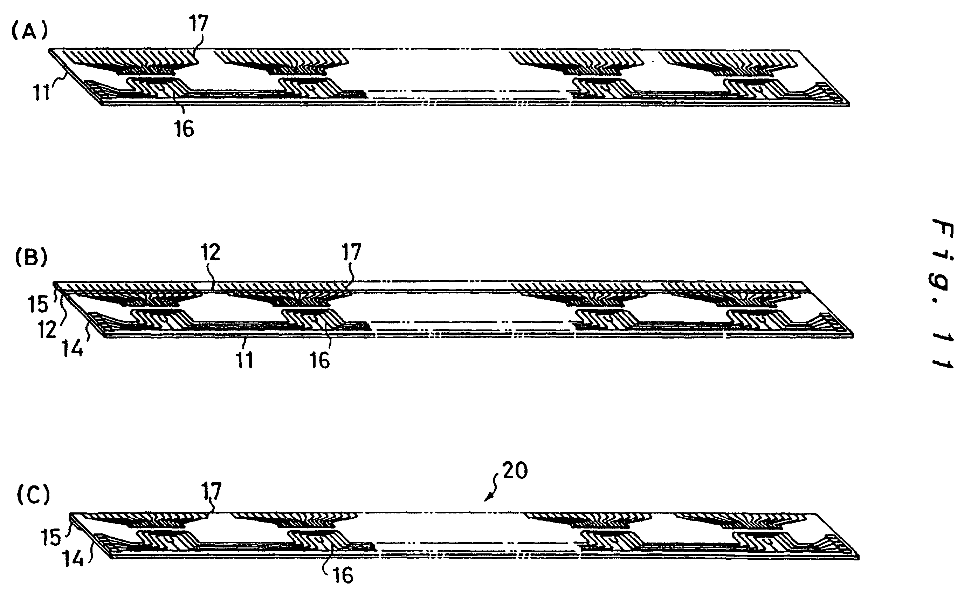

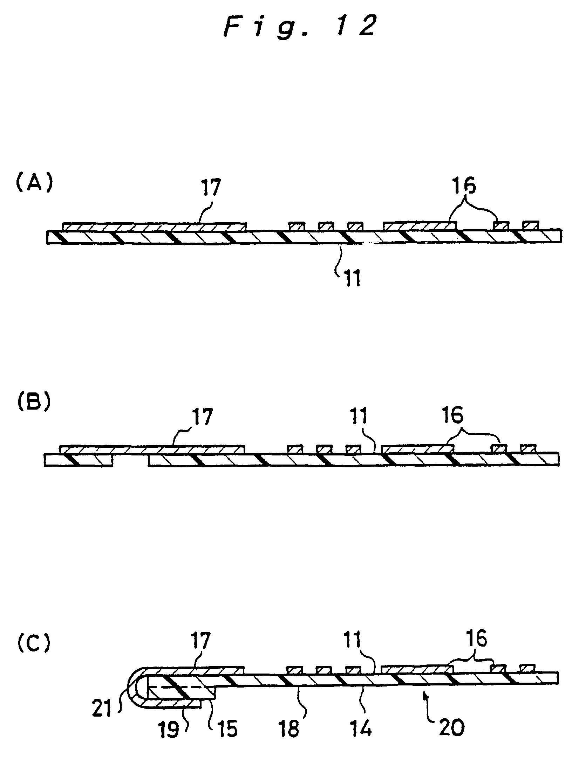

Shown in Figs. 11(A) - (C) and Figs. 12(A) - (C) is another example of the manufacturing method of a printed wiring board in the order of manufacturing steps. In this example, prepared first is the insulating board 11 made of polyimide-based resin having a thickness of 25 µm on top of which a conductive film made of electrolytic copper foil or the like having a thickness of 18 µm is attached as in the first example, and then the conductive film is patterned using a conventional technique such as photoetching to form desired conductor patterns 16, 17 (Fig. 11(A), Fig. 12(A)).

By directing an excimer laser to the insulating board 11 from its bottom side, the board material is cut along a predetermined fold physicochemically (abrasion) to form a cutout portion 12 made of a series of numerous slits (Fig. 11(B), Fig. 12(B)). The cutout portion may take any of the diversity of shapes described with reference to the first example as shown in Fig. 3. In yet another example, as described with reference to Fig. 8, the cutout portion may be constructed of a recess where part of the thickness of the board material to the conductor pattern side is left uncut. The insulating board 11 is folded with the conductor pattern 17 side out so that the second portion 15 is attached onto the bottom side 18 of the first portion 14. The first portion 14 and the second portion 15 are bonded into a unitary body by thermo-compression bonding them using a bonding agent in the same manner as in the first example.

In this example, by using an excimer laser, the cutout portion 12 is formed finely with a high accuracy. Since, unlike the first example, jigs or tools such as pressing dies or drills are not required, work is simplified and manufacturing cost is reduced.

Alternatively, a cutout portion is formed by directing an excimer laser to an insulating board, onto which a conductive film is bonded, from the bottom side of the insulating board, and then the conductive film is patterned to form a conductor pattern that runs across the cutout portion between the first portion and the second portion.

The printed wiring board of the present invention finds applications in a diversity of electronic apparatuses as will be exemplified below, but the present invention is not limited to these electronic apparatuses.

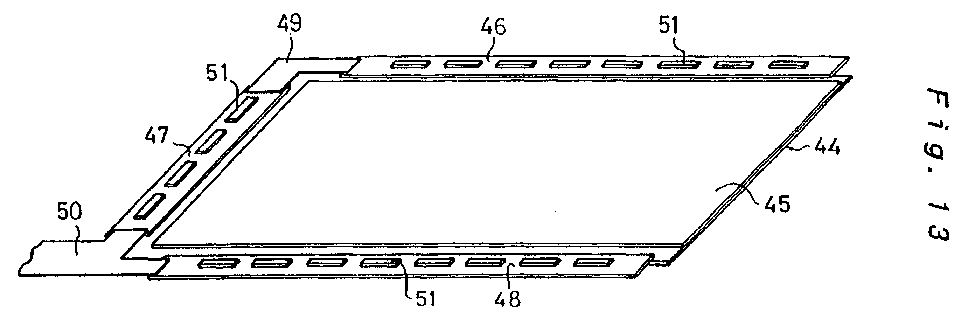

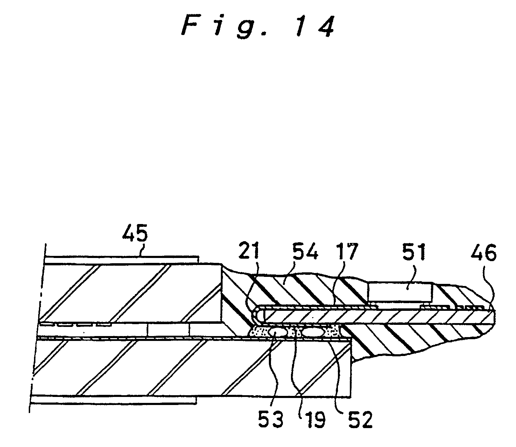

Fig. 13 and Fig. 14 show the liquid crystal display device 44 into which the present invention is embodied. The liquid crystal display device 44 comprises a liquid crystal panel 45 (display size of 640 x 480 dots) having an ordinary XY matrix electrode structure, which has elongated planar circuit boards 46 - 48 around its periphery, respectively on its top edge, left-hand side edge and bottom edge. The circuit board 46 and the circuit board 47 are connected via an extension board 49, and the circuit board 47 and the circuit board 48 are connected via an extension board 50 with which a cable for external connection is integrated.

As best seen from the cross-sectional view in Fig. 14, in the same way as the printed wiring board shown in Fig. 7(B), each of the circuit boards is constructed of a printed wiring board of the present invention wherein a first portion and a second portion in identical dimensions and identical shape are bonded to make substantially uniform the thickness of the insulating board and a liquid crystal driving semiconductor chip 51 is mounted on the printed wiring board. The semiconductor chip 51 is connected via a commonly available anisotropic conductive film. In this embodiment, the semiconductor chip is thermo-compression bonded using an anisotropic conductive film, which is made of both conductive particles that are formed of polystyrene particles of particle diameter 5 µm by applying Ni-Au plating thereon and a bonding agent containing epoxy-based bonding agent as its major constituent, under a temperature of 180 °C and a pressure of 10 gf/bump for a pressure application duration of 30 seconds. To bond the semiconductor chip 51, a diversity of known techniques may be used, for example the flip chip bonding process in which solder bumps and the like are directly face-down bonded, or another bonding process in which bumps of the semiconductor chip are directly bonded.

The output side of the liquid crystal driving semiconductor chip 51 is connected to the output terminal 19 on the bottom side via the conductor pattern 17 around the bent portion 21. The output terminal 19 is electrically and mechanically connected, via the anisotropic conductive layer 53, to an LCD terminal 52 formed on the periphery of the liquid crystal 45. In this embodiment, the anisotropic conductive layer 53 is made up of both conductive particles that are formed by coating polystyrene particles having a particle diameter of 10 µm with Ni-Au plating and a bonding agent containing epoxy-based bonding agent as its major constituent, and the anisotropic conductive layer 53 is bonded under the thermo-compression bonding conditions of a temperature of 170 °C and a pressure of 10 MPa for a pressure application duration of 20 seconds.

In yet another embodiment, only a bonding agent instead of the anisotropic conductive film is used to cause the output terminal 19 of the circuit board 46 to be in direct contact with the LCD terminal 52 for connection. In such a bonding method, the possibility of short circuit arising from the use of anisotropic conductive film is precluded, and a finer pitch wiring is thus achieved. In the same way, the circuit boards are connected to the extension boards 49, 50 via an anisotropic conductive film. In this embodiment, an anisotropic conductive film made of nickel metal particles having a particle diameter of 5 µm and a bonding agent containing an epoxy-based bonding agent as its major constituent is thermo-compression bonded under the condition of a temperature of 170°C and a pressure of 3 MPa for a pressure application duration of 20 seconds.

Silicone resin, acrylic resin, urethane resin or the like are molded around the circuit boards 46 - 48, the joint portion between the liquid crystal driving semiconductor chip 51 and the liquid crystal panel 45, and the joint portions of the extension boards 49, 50, respectively, to keep out moisture and dirt and to seal them against mechanical contact for damage prevention.

According to this embodiment, since the circuit boards 46 - 38 are kept to within the thickness of the liquid crystal panel 45 and the area of each circuit board that projects outwardly in the plane of the liquid crystal panel 45 is narrowed, the periphery portion of the liquid crystal panel is reduced, promoting a compact structure of the liquid crystal display device through a miniature, light-weight and flat design. Since the manufacturing cost of the circuit board is reduced and the number of joints with the liquid crystal panel and joints between the circuit boards is also reduced, the cost for mounting and the cost for manufacturing the liquid crystal display device are reduced.

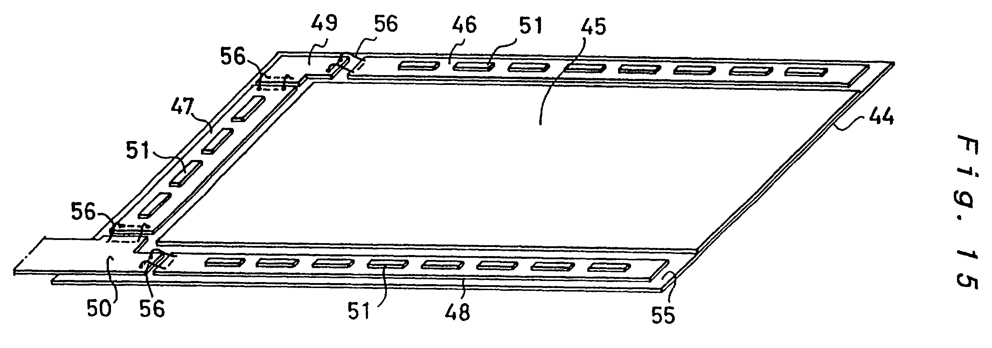

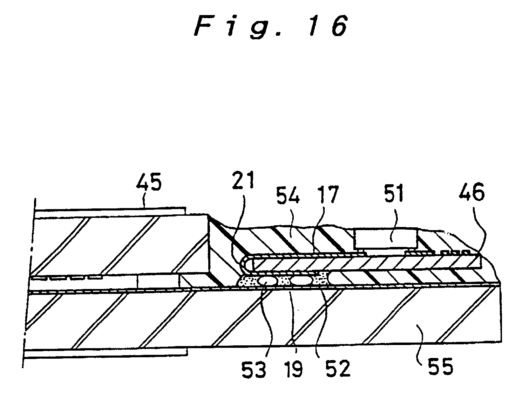

Fig. 15 and Fig. 16 show the alternate example of the above-described liquid crystal display device. This embodiment is different from the first embodiment in Fig. 13 and Fig. 14 in that the periphery portion 55 of the liquid crystal panel 45 is enlarged so that the circuit boards 46 - 48 entirely lie within the plane of the periphery portion 55, and that instead of the anisotropic conductive film, wires 56 constructed of a metal such as Au, Al or Cu or an alloy made of these metals are wire bonded to connect the circuit boards to the respective extension boards 49, 50. In this embodiment, in addition to the advantage of the first embodiment, the circuit boards 46 - 48 are supported on their entire areas by the periphery portion 55 of the liquid crystal panel, and are thus reinforced against vibrations and shocks, and a highly reliable liquid crystal display device results.

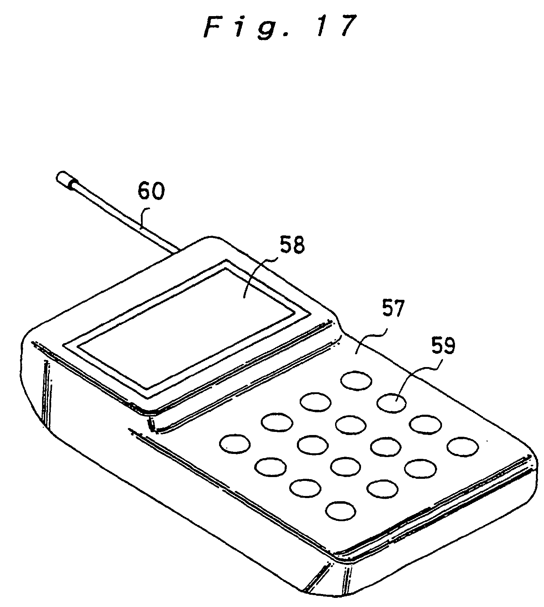

The liquid crystal display device of the present invention described above may be assembled into a portable information apparatus 57 to be used as display means 58 for it as shown in Fig. 17. This portable information apparatus has a function that allows information to be bilaterally exchanged through a communications antenna 60 by entering data with keys 59 on the apparatus from indoors, outdoors or even in a running electric car or a running automobile. As described above, since the liquid crystal display device of the present invention has a miniature, light-weight and flat construction, the periphery portion is reduced, and the display area is accordingly enlarged for a better visibility, the portable information apparatus 57 that employs the liquid crystal display device makes a compact apparatus through a miniature, light-weight and flat design, and is also easy to carry and handle, offers an improved operability to the extent that permits a single-handed operation, increases the quantity of on-screen information, and presents high-performance and multi-function features.

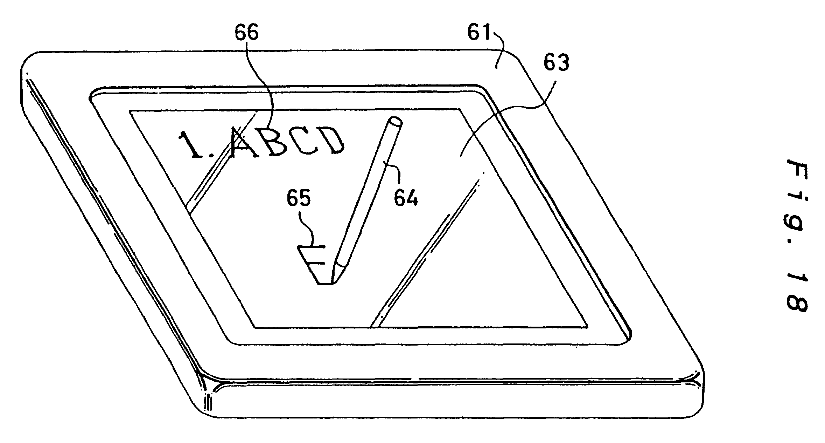

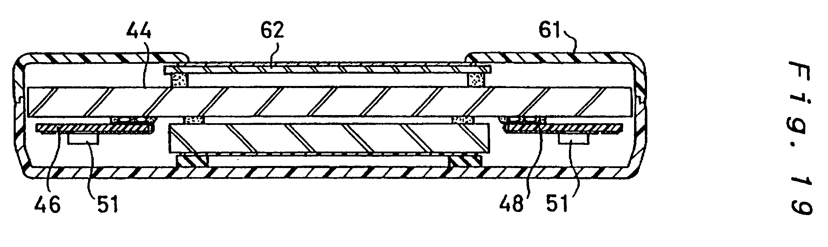

Fig. 18 and Fig. 19 show an electronic apparatus 61 that contains an input/output device that is the above-described liquid crystal display device of the present invention into which a touch panel as an input device is integrated. Such an electronic apparatus is used, for example, as a terminal for an information network or as a portable computer. As shown in Fig. 19, a touch panel 62 is attached on the liquid crystal display device 44 which connect to circuit boards 46, 48 that are the printed wiring boards of the present invention on which liquid crystal semiconductor chips 51 mounted.

As shown in Fig. 18, when a character 65 or a symbol or a figure is drawn on an input/output screen 63 using an input pen 64, it is presented as display characters 66 or the like on screen. When a symbol or a figure called an icon presented on screen is touched with the input pen or a finger, the process responsive to that input is executed. In this embodiment as well, the liquid crystal display device has a miniature, light-weight, and flat construction, with a narrowed periphery portion and accordingly a widened screen area for a better visibility, the electronic apparatus 61 thus makes a compact apparatus through a miniature, light-weight and flat design, and is easy to operate, offers a larger quantity of on-screen information, and thus presents high-performance and multi-function features.

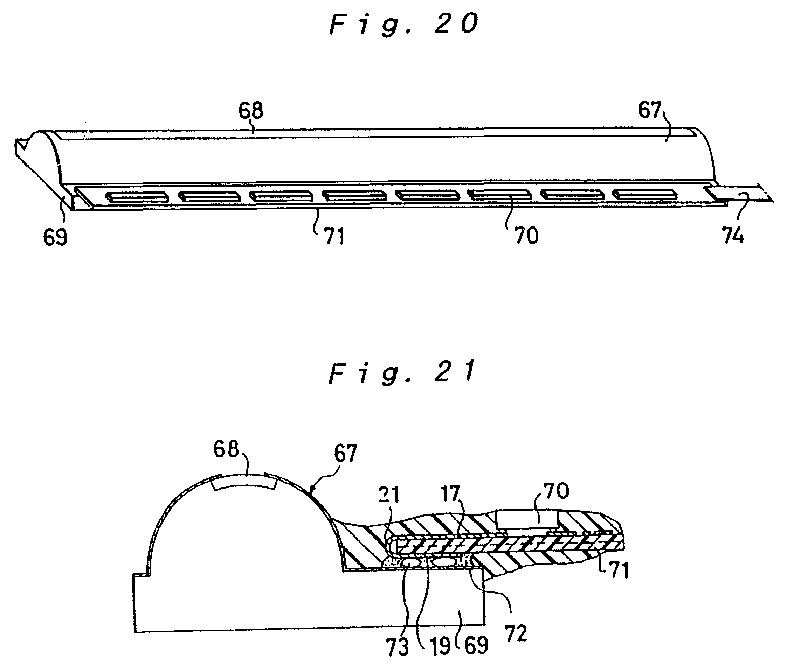

Fig. 20 and Fig. 21 show a thermal printer head 67 for use in an electronic printer apparatus into which the present invention is embodied. In the thermal printer head 67, a circuit board 71 on which a driving semiconductor chip 70 is mounted using prior art techniques such as an anisotropic conductive film is connected to a ceramic substrate 69 that constitutes a heater block 68. Like the circuit board in the first embodiment of the liquid crystal display device described above, the circuit board 71 is electrically and mechanically connected to a terminal 72 formed on the substrate 69 of the thermal printer head 67 by means of thermo-compression bonding using a prior art anisotropic conductive film 73. Naturally, the circuit board 71 may be equally connected using another method among a diversity of prior art methods. The circuit board 71 on the other end is connected, for example, via an anisotropic conductive film to a cable 74 that is in turn connected to an external apparatus or the main unit side of the electronic apparatus.

According to the above embodiment, by employing the above-described circuit board, the circuit area required for driving the thermal printer head 67 is reduced, and the miniature, light-weight and flat design of the thermal printer head is promoted. Since the manufacturing cost for the circuit board is reduced and the number of joints with the thermal printer head and the joints between the circuit boards is reduced, the cost required for assembling the head and circuit boards and the manufacturing cost for the thermal printer head and the electronic apparatus on which the thermal printer head is installed are reduced.

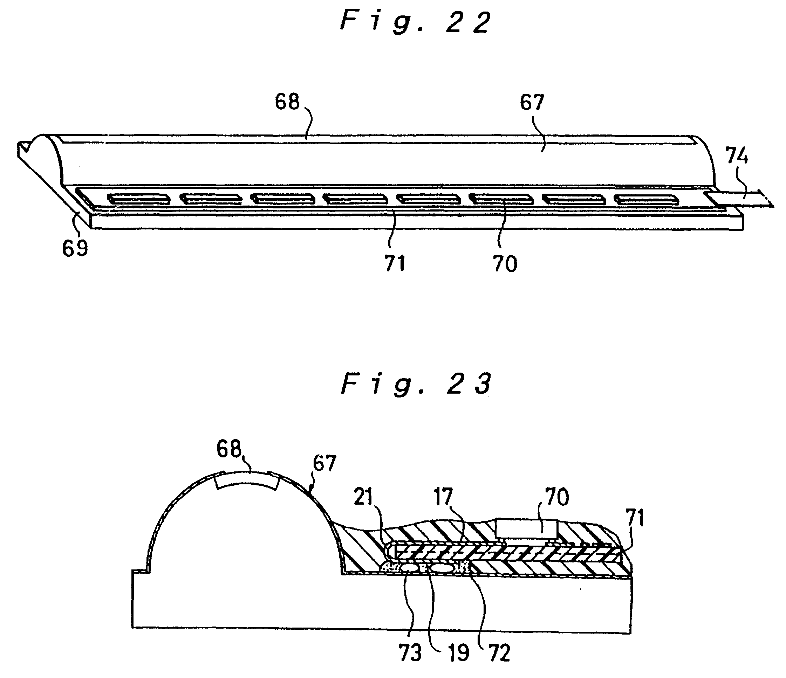

Fig. 22 and Fig. 23 show an alternate example of the above-described thermal printer head. This alternate embodiment is different from the first embodiment of the thermal printer head in that the substrate 69 of the thermal printer head 67 is enlarged so that the entire circuit board 71 lies in the plane of the substrate 69. According to this embodiment, in addition to the advantage of the first embodiment, the circuit board 71 is integrated on its entire area with the substrate 69, and is thus reinforced against vibrations and shocks of the thermal printer head 67, and a highly reliable thermal printer head 67 thus results.

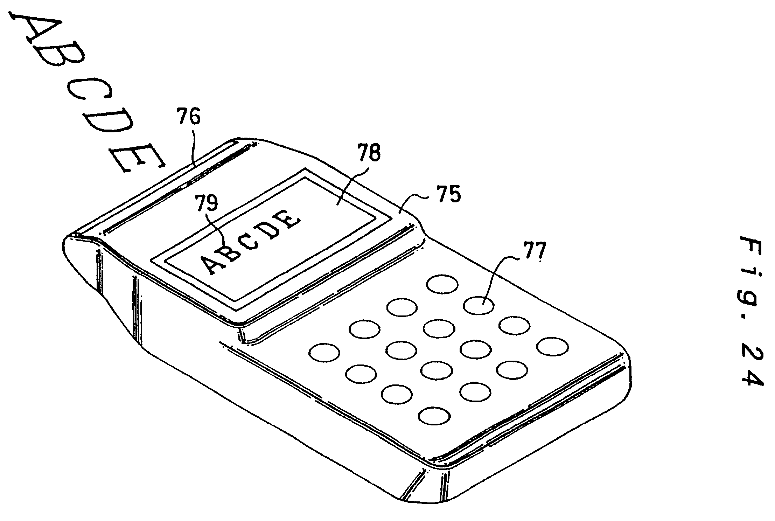

Shown in Fig. 24 is a portable electronic printer apparatus 75 that contains the thermal printer head of the present invention. The portable electronic printer apparatus is compact enough to be operated in the palm of a single hand, and has on its forward end a printer block 76 in which the thermal printer head is built in. When characters or symbols are entered via input keys 77, they are presented on a liquid crystal display screen 78, and when the printer block 76 is moved on the surface of a sheet of paper or the like on which printout is wanted, displayed characters 79 or symbols are printed there. Not only characters or symbols but also figures, bar codes or the like are printable, and furthermore, information coming in through radio link or communications cable from external equipment may be input to the apparatus to be printed, and the apparatus is particularly handy to attach notes such as bar codes, advertisements for selling points, and explanations to items arranged in a showcase in a store or the like.

In such an electronic printer apparatus, by employing a low-cost and compact thermal printer head of a miniature, light-weight and flat design, a compact and low-cost host apparatus results through a miniature, light-weigh and flat design. In particular, when the thermal printer head of the second embodiment described above is used, an electronic printer apparatus robust to vibrations and shocks is obtained. By employing the above-described liquid crystal display device of the present invention for the display screen 78, an even more miniature, light-weight, flat and low-cost electronic printer apparatus results.

The present invention is not limited to the above described embodiments, and it will be apparent to those skilled in the art that a diversity of variations and modifications can be carried out to the preceding embodiments without departing from the technical scope defined by the claims.

## Claims

1. A multi-layered printed wiring board comprising a pair of outer layers (36, 37) made of insulating material, one or more inner layers (38) made of insulating material sandwiched between the outer layers (36, 37), and conductor patterns (39) formed between the neighboring outer layers (36, 37) and inner layers (38),
one of the outer layers (36, 37) having a first portion (40) that is attached onto the neighboring inner layer (38) and a second portion (42) that is folded along a fold back over the other outer layer, and
said one outer layer (36) having a cutout portion (41) that is formed by cutting out partly the insulating material along the fold, wherein a conductor pattern (43) is formed on top of said one outer layer (36), said conductor pattern (43) continuously extending across the fold at the cutout portion (41) between the first portion (40) and the second portion (42).

2. The printed wiring board according to claim 1 having a plurality of second portions (42).

3. The printed wiring board according to claim 1 or 2, wherein said cutout portion (41) extends over the entire length of the fold.

4. The printed wiring board according to claim 1 or 2, wherein said cutout portion (41) extends over only part of the fold where the conductor pattern (43) is formed.

5. The printed wiring board according to claims 3 or 4, wherein said cutout portion (41) is made up of a plurality of small holes punched through the insulating board.

6. The printed wiring board according to claims 3 or 4, wherein said cutout portion (41) is made up of a single slot or a plurality of slots.

7. The printed wiring board according to claims 3 or 4, wherein said cutout portion (41) is made up of a groove.

8. The printed wiring board according to any one of the preceding claims, wherein said outer layers (36, 37) are constructed of a composite material that is made of glass fiber, aramid fiber, a mixture of glass fiber and aramid fiber and epoxy resin, polyimide resin, BT ((bismaleimide triazine) resin or the like.

9. The printed wiring board according to any one of the preceding claims, wherein said outer layers (36, 37) are constructed of a single material or a mixture of materials or a combination of materials selected from epoxy-based resin, polyimide-based resin, BT based resin and polyester-based resin.

10. A method of manufacturing a multi-layered printed wiring board with a first and a second outer layer (36, 37) made of insulating material, comprising the steps of forming a cutout portion (41) in the first outer layer (36) by cutting out partly the insulating material of the first outer layer (36) along a fold that partitions the first outer layer (36) into a first portion (40) and a second portion (42), forming and then patterning a conductive film on the surface of the first outer layer (36) to form a conductor pattern (43) that continuously extends across the fold at the cutout portion (41) between the first portion (40) and the second portion (42), and folding the first outer layer (36) along the fold with its conductor pattern side facing outwardly, such that the second portion (42) of the first outer layer (36) is folded back onto and attached to the second outer layer (37).

11. The method of claim 10, wherein said cutout portion (41) is formed by pressing or drilling.

12. The method of claim 10, wherein the cutout portion (41) is formed by means of an excimer laser.

13. The method according to claim 10, wherein the folded-back second portion (42) is bonded to the second outer layer (37) by means of a bonding agent.

14. The method of claim 10, wherein the folded-back second portion (42) is bonded to the second outer layer (37) by means of thermal fusing.

15. An electronic apparatus comprising the printed wiring board (46-48) defined in any one of claims 1 to 9.

16. The electronic apparatus according to claim 15 comprising a liquid crystal display device that is constructed by connecting a liquid crystal panel to the printed wiring board on which a liquid crystal driving semiconductor chip is mounted.

17. The electronic apparatus according to claim 16 comprising as an input device a touch panel that is integrated with the liquid crystal display device.

18. The electronic apparatus according to claim 15 comprising as electronic printer means a thermal printer head that is connected to the printed wiring board on which a driving semiconductor chip is mounted.

## Patentansprüche

1. Gedruckte Vielschicht-Leiterplatte mit einem Paar von Außenschichten (36, 37) aus isolierendem Material, einer oder mehreren Innenschichten (38) aus isolierendem Material, die zwischen den Außenschichten (36, 37) liegen, und Leitermustern (39), die zwischen benachbarten Außenschichten (36,37) und Innenschichten (38) gebildet sind,
wobei eine der Außenschichten (36,37) einen ersten Abschnitt (40), der an der benachbarten lnnenschicht(38) befestigt ist, und einen zweiten Abschnitt (42) hat, der entlang einer Falte über die Außenschicht zurück gefaltet ist, und
die besagte eine Außenschicht (36) einen ausgeschnittenen Abschnitt (41) hat, der durch teilweises Ausschneiden des isolierenden Materials entlang der Falte gebildet ist, wobei ein Leitermuster (43) auf der einen Außenschicht (36) gebildet ist, und das Leitermuster (43) sich kontinuierlich über die Falte an dem ausgeschnittenen Abschnitt (41) zwischen dem ersten Abschnitt (40) und dem zweiten Abschnitt (42) erstreckt.

2. Gedruckte Leiterplatte nach Anspruch 1 mit einer Mehrzahl von zweiten Abschnitten (42).

3. Gedruckte Leiterplatte nach Anspruch 1 oder 2, bei der sich der ausgeschnittene Abschnitt (41) über die gesamte Länge der Falte erstreckt.

4. Gedruckte Leiterplatte nach Anspruch 1 oder 2, bei der sich der ausgeschnittene Abschnitt (41) nur über einen Teil der Falte, wo das Leitermuster (43) gebildet ist, erstreckt.

5. Gedruckte Leiterplatte nach Anspruch 3 oder 4, bei der der ausgeschnittene Abschnitt (41) aus einer Mehrzahl von durch die isolierende Platte gestanzten kleinen Löchern gebildet ist.

6. Gedruckte Leiterplatte nach Anspruch 3 oder 4, bei der der ausgeschnittene Abschnitt (41) durch einen einzelnen Schlitz oder eine Mehrzahl von Schlitzen gebildet ist.

7. Gedruckte Leiterplatte nach Anspruch 3 oder 4, bei der der ausgeschnittene Abschnitt (41) durch eine Rille gebildet ist.

8. Gedruckte Leiterplatte nach einem der vorhergehenden Ansprüche, bei der die Außenschichten (36, 37) aus einem Verbundmaterial aufgebaut sind, das aus Glasfaser, Aramidfaser, einem Gemisch von Glasfaser und Aramidfaser und Epoxyharz, Polyimidharz, BT-(Bismaleimid-Triazin)-Harz oder dergleichen gemacht ist.

9. Gedruckte Leiterplatte nach einem der vorhergehenden Ansprüche, bei der die Außenschichten (36,37) aus einem einzelnen Material oder einem Gemisch von Materialien oder einer Kombination von Materialien aufgebaut sind, die ausgewählt sind unter epoxybasiertem Harz, polyimidbasiertem Harz, BT-basiertem Harz und polyesterbasiertem Harz.

10. Verfahren zur Herstellung einer gedruckten Vielschicht-Leiterplatte mit einer ersten und einer zweiten Außenschicht (36, 37) aus isolierendem Material, mit den Schritten des Bildens eines ausgeschnittenen Abschnitts (41) in der ersten Außenschicht (36) durch teilweises Ausschneiden des isolierenden Materials der ersten Außenschicht (36) entlang einer Falte, die die erste Außenschicht (36) in einen ersten Abschnitt (40) und einen zweiten Abschnitt (42) unterteilt, Bilden und dann Strukturieren eines leitfähigen Films auf der Oberfläche der ersten Außenschicht (36), um ein Leitermuster (43) zu bilden, das sich kontinuierlich über die Falte an dem ausgeschnittenen Abschnitt (41) zwischen den ersten Abschnitt (40) und dem zweiten Abschnitt (42) erstreckt, und Falten der ersten Außenschicht (36) entlang der Falte mit nach außen gerichtetem Leitermuster, so dass der zweite Abschnitt (42) der ersten Außenschicht (36) auf die zweite Außenschicht (37) zurück gefaltet und an ihr befestigt wird.

11. Verfahren nach Anspruch 10, bei dem der ausgeschnittene Abschnitt (41) durch Pressen oder Bohren gebildet wird.

12. Verfahren nach Anspruch 10, bei dem der ausgeschnittene Abschnitt (41) mit Hilfe eines Excimerlasers gebildet wird.

13. Verfahren nach Anspruch 10, bei dem der zurück gefaltete zweite Abschnitt (42) an die zweite Außenschicht (37) durch ein Bondmittel gebondet wird.

14. Verfahren nach Anspruch 10, bei dem der zurück gefaltete zweite Abschnitt (42) an die zweite Außenschicht (37) durch thermisches Schmelzen gebondet wird.

15. Elektronisches Gerät mit der Leiterplatte (46-48) nach einem der Ansprüche 1 bis 9.

16. Elektronisches Gerät nach Anspruch 15 mit einer Flüssigkristall-Anzeigevorrichtung, die aufgebaut ist durch Verbinden eines Flüssigkristall-Anzeigeschirms mit der gedruckten Leiterplatte, auf der ein Flüssigkristalltreiber-Halbleiterchip montiert ist.

17. Elektronisches Gerät nach Anspruch 16, das als eine Eingabevorrichtung ein Touchpanel umfasst, das mit der Flüssigkristall-Anzeigevorrichtung integriert ist.

18. Elektronisches Gerät nach Anspruch 15, das als elektronische Druckeinrichtung einen Thermodruckkopf umfasst, der mit der gedruckten Leiterplatte verbunden ist, auf der ein Treiber-Halbleiterchip montiert ist.

## Revendications

1. Carte à circuit imprimé multicouche comprenant une paire de couches extérieures (36, 37) constituées d'un matériau isolant, une ou plusieurs couches intérieures (38) constituées d'un matériau isolant, prises en sandwich entre les couches extérieures (36, 37), et des tracés conducteurs (39) formés entre les couches extérieures (36, 37) et les couches intérieures (38) voisines,
l'une des couches extérieures (36, 37) comprenant une première portion (40) qui est fixée sur la couche intérieure (38) voisine et une deuxième portion (42) qui est repliée le long d'une pliure sur l'autre couche extérieure, et
ladite une couche extérieure (36) ayant une portion découpée (41) qui est formée en découpant partiellement le matériau isolant le long de la pliure, dans laquelle un tracé conducteur (43) est formé sur la face supérieure de ladite une couche extérieure (36), ledit tracé conducteur (43) s'étendant en continu en travers de la pliure au niveau de la portion découpée (41) entre la première portion (40) et la deuxième portion (42).

2. Carte à circuit imprimé selon la revendication 1, comportant une pluralité de deuxièmes portions (42).

3. Carte à circuit imprimé selon la revendication 1 ou 2, dans laquelle la portion découpée (41) s'étend sur toute la longueur de la pliure.

4. Carte à circuit imprimé selon la revendication 1 ou 2, dans laquelle la portion découpée (41) s'étend sur uniquement une partie de la pliure sur laquelle le tracé conducteur (43) est formé.

5. Carte à circuit imprimé selon la revendication 3 ou 4, dans laquelle la portion découpée (41) est constituée d'une pluralité de petits trous percés à travers la carte isolante.

6. Carte à circuit imprimé selon la revendication 3 ou 4, dans laquelle la portion découpée (41) est constituée d'une seule fente ou d'une pluralité de fentes.

7. Carte à circuit imprimé selon la revendication 3 ou 4, dans laquelle la portion découpée (41) est constituée d'une rainure.

8. Carte à circuit imprimé selon l'une quelconque des revendications précédentes, dans laquelle les couches extérieures (36, 37) sont constituées d'un matériau composite fait de fibres de verre, de fibres aramides, d'un mélange de fibres de verre et de fibres aramides, et de résine époxyde, de résine de polyimide, de résine BT (bismaléimide triazine) ou analogue.

9. Carte à circuit imprimé selon l'une quelconque des revendications précédentes, dans laquelle les couches extérieures (36, 37) sont constituées d'un unique matériau ou d'un mélange de matériaux ou d'une combinaison de matériaux choisis parmi une résine à base d'époxy, une résine à base de polyimide, une résine à base de BT et une résine à base de polyester.

10. Procédé de fabrication d'une carte à circuit imprimé multicouche comprenant une première et une deuxième couches extérieures (36, 37) constituées d'un matériau isolant, comprenant les étapes consistant à former une portion découpée (41) dans la première couche extérieure (36) en découpant partiellement le matériau isolant de la première couche extérieure (36) le long d'une pliure qui sépare cette couche en une première portion (40) et une deuxième portion (42), à former, puis à configurer un film conducteur sur la surface de la première couche extérieure (36) pour former un tracé conducteur (43) qui s'étend en continu en travers de la pliure au niveau de la portion découpée (41) entre la première portion (40) et la deuxième portion (42), et à plier la première couche extérieure (36) le long de la pliure, son côté portant le tracé conducteur étant tourné vers l'extérieur, de sorte que la deuxième portion (42) de la première couche extérieure (36) soit repliée et fixée sur la deuxième couche extérieure (37).

11. Procédé selon la revendication 10, dans lequel la portion découpée (41) est formée par découpage à la presse ou perçage.

12. Procédé selon la revendication 10, dans lequel la portion découpée (41) est formée au moyen d'un laser à excimère.

13. Procédé selon la revendication 10, dans lequel la deuxième portion (42) repliée est liée à la deuxième couche extérieure (37) au moyen d'un adhésif.

14. Procédé selon la revendication 10, dans lequel la deuxième portion (42) repliée est liée à la deuxième couche extérieure (37) par thermosoudage.

15. Dispositif électronique comprenant la carte à circuit imprimé (46-48) définie dans l'une quelconque des revendications 1 à 9.

16. Dispositif électronique selon la revendication 15, comprenant un dispositif d'affichage à cristaux liquides qui est construit en raccordant un écran à cristaux liquides à la carte à circuit imprimé sur laquelle est montée une puce à semi-conducteur commandant les cristaux liquides.

17. Dispositif électronique selon la revendication 16, comprenant un écran tactile, utilisé comme dispositif d'entrée, qui est intégré au dispositif d'affichage à cristaux liquides.

18. Dispositif électronique selon la revendication 15, comprenant une imprimante thermique, utilisée comme moyen électronique d'impression, qui est raccordée à la carte à circuit imprimé sur laquelle une puce à semi-conducteur de commande est montée.
